# EUROPEAN PATENT APPLICATION

(11) **EP 2 172 975 A2**
(43) Date of publication of application: **07.04.2010**
(21) Application number: 09012585.7
(22) Date of filing: 05.10.2009
(51) Int. Cl.: H01L 29/739

(54) **Insulated gate bipolar transistor**

(30) Priority: 06.10.2008 JP 2008259838
(71) Applicant: NEC Electronics Corporation, Kawasaki, Kanagawa 211-8668 (JP)
(72) Inventor: Ito, Masayuki, Kawasaki, Kanagawa 211-8668 (JP)
(74) Representative: Glawe, Delfs, Moll

(57) **Abstract**

Provided is an insulated gate bipolar transistor (IGBT) which occupies a small area and in which a thermal breakdown is suppressed. The IGBT includes: an n-type semiconductor layer (3); and a collector part formed in a surface portion of the n-type semiconductor layer (3). The collector part includes: an n-type buffer region (14); and a p⁺-type collector region (15) and an n⁺-type contact region (18) which are formed in the n-type buffer region (14).

## Description

### BACKGROUND OF THE INVENTION

### 1. Field of the Invention

The present invention relates to an insulated gate bipolar transistor (IGBT).

### 2. Description of the Related Art

An insulated gate bipolar transistor (IGBT) is one of semiconductor elements that are widely used as a power device. In particular, a lateral IGBT is excellent in withstand voltage and, moreover, may be monolithically integrated with another semiconductor element. Therefore, the lateral IGBT is attracting attention in recent years.

As disclosed in JP 10-200102 A, in a case where the IGBT is used, a diode is generally connected in parallel with the IGBT in order to secure a current path during a reverse conduction state. The IGBT is normally applied with a bias such that a voltage at a collector thereof is higher than a voltage at an emitter thereof, with the result that a current flows from the collector to the emitter. However, depending on an operation state of the IGBT, the voltage at the emitter may be higher than the voltage at the collector. The diode provides a path that allows a current to flow from the emitter to the collector in such a case.

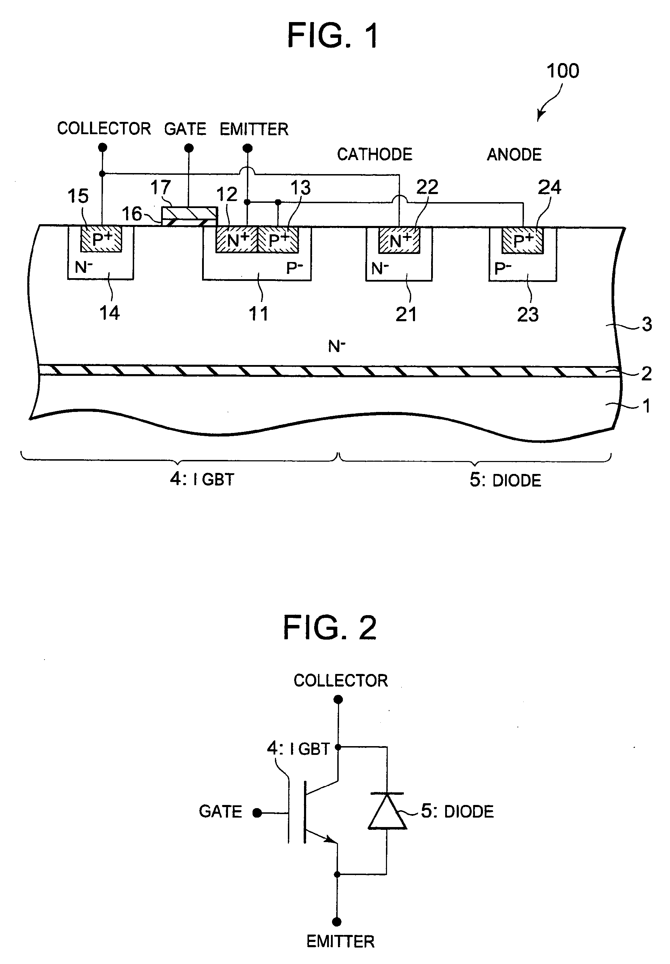

FIG. 1 is a cross sectional view illustrating a typical structure of a semiconductor device 100 in which a lateral IGBT and a diode are monolithically integrated. In the following description, "n⁺-type" indicates that n-type impurities are doped at a concentration high enough that a semiconductor is degenerated, and "p⁺-type" indicates that p-type impurities are doped at a concentration high enough that a semiconductor is degenerated. On the other hand, "n-type" or "p-type" indicates that n-type impurities or p-type impurities are doped at a low concentration (a concentration low enough that a semiconductor is not degenerated).

As illustrated in FIG. 1, an insulating layer 2 is formed on a semiconductor substrate 1, and an n-type semiconductor layer 3 serving as a substrate region is formed on the insulating layer 2. A lateral IGBT 4 and a lateral diode 5 are formed in a surface portion of the n-type semiconductor layer 3.

The structure of the lateral IGBT 4 is as follows. Ap-type well region 11 is formed in the surface portion of the n-type semiconductor layer 3. An n⁺-type source region 12 and a p⁺-type contact region 13 are formed in the p-type well region 11. The p-type well region 11, the n⁺-type source region 12, and the p⁺-type contact region 13 function as an emitter part of the IGBT 4. Further, an n-type buffer region 14 is formed separately from the p-type well region 11. A p⁺-type collector region 15 is formed in the n-type buffer region 14. The n-type buffer region 14 and the p⁺-type collector region 15 function as a collector part of the IGBT 4. A gate insulating film 16 is formed in a portion of the n-type semiconductor layer 3 between the n⁺-type source region 12 and the n-type buffer region 14. A gate electrode 17 is formed on the gate insulating film 16. The gate insulating film 16 and the gate electrode 17 are formed so as to cover a part of the p-type well region 11.

On the other hand, the structure of the lateral diode 5 is as follows. An n-type diffusion region 21 is formed in the surface portion of the n-type semiconductor layer 3. An n⁺-type cathode region 22 is formed in a surface portion of the n-type diffusion region 21. The n-type diffusion region 21 and the n⁺-type cathode region 22 function as a cathode of the lateral diode 5. In addition, a p-type diffusion region 23 is formed separately from the n-type diffusion region 21. A p⁺-type anode region 24 is formed in a surface portion of the p-type diffusion region 23. The p-type diffusion region 23 and the p⁺-type anode region 24 function as an anode of the lateral diode 5.

FIG. 2 is an equivalent circuit diagram of the semiconductor device 100 of FIG. 1. In the structure of FIG. 1, the anode of the lateral diode 5 is connected to the emitter of the IGBT 4, and the cathode of the lateral diode 5 is connected to the collector of the IGBT 4. When a voltage at the emitter of the IGBT 4 becomes higher than a voltage at the collector thereof, a current starts to flow from the anode of the lateral diode 5 to the cathode thereof.

JP 10-200102 A described above also discloses the lateral IGBT which is integrated with a metal oxide semiconductor field effect transistor (MOSFET), instead of the diode. A parasitic diode is formed in the MOSFET, and the parasitic diode thus formed may serve as a current path during a reverse conduction state.

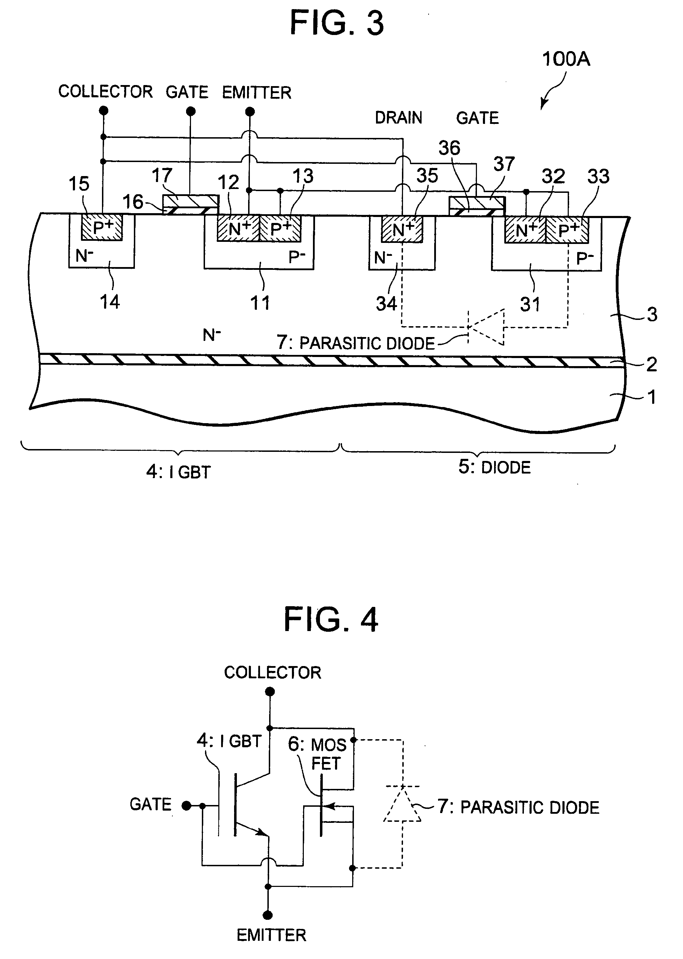

FIG. 3 is a cross sectional view illustrating a typical structure of such a semiconductor device 100A. In the semiconductor device 100A of FIG. 3, a lateral MOSFET 6 is formed instead of the lateral diode 5 of the semiconductor device 100 of FIG. 1. The structure of the lateral MOSFET 6 is as follows. A p-type well region 31 is formed in the surface portion of the n-type semiconductor layer 3. An n⁺-type source region 32 and a p⁺-type contact region 33 are formed in the p-type well region 31. An n-type buffer region 34 is formed separately from the p-type well region 31. An n⁺-type drain region 35 is formed in the n-type buffer region 34. A gate insulating film 36 is formed in a portion of the n-type semiconductor layer 3 between the n⁺-type source region 32 and the n-type buffer region 34. A gate electrode 37 is formed on the gate insulating film 36. The gate insulating film 36 and the gate electrode 37 are formed so as to cover a part of the p-type well region 31. In the above-mentioned structure, the p⁺-type contact region 33, the p-type well region 31, the n-type semiconductor layer 3, the n-type buffer region 34, and the n⁺-type drain region 35 form a parasitic diode 7.

FIG. 4 is an equivalent circuit diagram of the semiconductor device 100A of FIG. 3. The MOSFET 6 is connected in parallel with the IGBT 4. In this case, the parasitic diode 7 of the MOSFET 6 has an anode connected to the emitter of the IGBT 4 and a cathode connected to the collector of the IGBT 4. Accordingly, in the structure of FIG. 3, the parasitic diode 7 may serve as a current path during a reverse conduction state. Moreover, in the structure of FIG. 3, a current is allowed to flow in the lateral MOSFET 6 as well as in the lateral IGBT 4 during a forward conduction state, and hence the semiconductor device is enhanced in driving performance.

However, the semiconductor devices of FIG. 1 and FIG. 3 both have the following two problems. One of the problems is a thermal breakdown. A current density of the lateral IGBT is apt to be high in a case of a forward current, which easily leads to the problem of thermal breakdown. Another one of the problems is that both of the semiconductor devices occupy a large area. In the semiconductor devices of FIG. 1 and FIG. 3, the diode or the MOSFET is integrated independently of the lateral IGBT. According to the study of the inventors of the present invention, such a method uselessly increases the area of the IGBT.

### SUMMARY OF THE INVENTION

An insulated gate bipolar transistor (IGBT) according to the present invention includes: a substrate region; and a collectorpart formed in a surface portion of the substrate region. The collector part includes: a buffer region; a p⁺-type region formed in the buffer region; and an n⁺-type region formed in the buffer region.

According to the present invention, an IGBT which occupies a small area, and in which a thermal breakdown is suppressed may be provided.

### BRIEF DESCRIPTION OF THE DRAWINGS

In the accompanying drawings:
FIG. 1 is a cross sectional view illustrating a typical structure of a semiconductor device in which a lateral IGBT and a diode are monolithically integrated;
FIG. 2 is an equivalent circuit diagram of the semiconductor device of FIG. 1;
FIG. 3 is a cross sectional view illustrating a typical structure of a semiconductor device in which a lateral IGBT and a MOSFET are monolithically integrated;
FIG. 4 is an equivalent circuit diagram of the semiconductor device of FIG. 3;
FIG. 5 is a cross sectional view illustrating a structure of a semiconductor device according to an embodiment of the present invention; and
FIG. 6 is an equivalent circuit diagram of the semiconductor device of FIG. 5.

### DETAILED DESCRIPTION OF THE PREFERRED EMBODIMENT

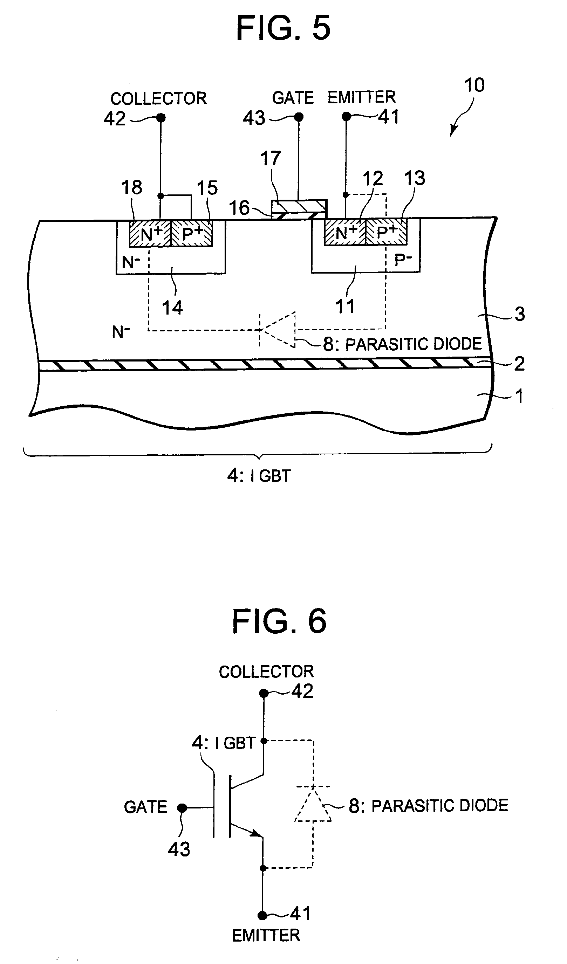

FIG. 5 is a cross sectional view illustrating a structure of a semiconductor device 10 according to an embodiment of the present invention. FIG. 6 is an equivalent circuit diagram of the semiconductor device 10 of FIG. 5. As illustrated in FIG. 5, the semiconductor device 10 of this embodiment has a silicon-on-insulator (SOI) structure. Specifically, an insulating layer 2 (typically, layer made of a silicon oxide film) is formed on a semiconductor substrate 1, and an n-type semiconductor layer 3 serving as a substrate region is formed on the insulating layer 2. The semiconductor substrate 1 may be any of p-type or n-type.

A lateral insulated gate bipolar transistor (IGBT) 4 is formed in a surface portion of the n-type semiconductor layer 3. The structure of the lateral IGBT 4 is as follows. A p-type well region 11 is formed in the surface portion of the n-type semiconductor layer 3. An n⁺-type source region 12 and a p⁺-type contact region 13 are formed in the p-type well region 11. The p-type well region 11, the n⁺-type source region 12, and the p⁺-type contact region 13 function as an emitter part of the IGBT 4. The n⁺-type source region 12 and the p⁺-type contact region 13 are connected to an emitter terminal 41.

Further, an n-type buffer region 14 is formed separately from the p-type well region 11. A p⁺-type collector region 15 and an n⁺-type contact region 18 are formed in the n-type buffer region 14. An impurity concentration of the n-type buffer region 14 is set to be higher than an impurity concentration of the n-type semiconductor layer 3. The n-type buffer region 14, the p⁺-type collector region 15, and the n⁺-type contact region 18 function as a collector part of the IGBT 4. The p⁺-type collector region 15 and the n⁺-type contact region 18 are connected to a collector terminal 42.

In addition, a gate insulating film 16 is formed in a portion of the n-type semiconductor layer 3 between the n⁺-type source region 12 and the n-type buffer region 14. A gate electrode 17 is formed on the gate insulating film 16. The gate insulating film 16 and the gate electrode 17 are formed so as to cover a part of the p-type well region 11. The gate electrode 17 is connected to a gate terminal 43.

An important feature of the semiconductor device 10 of this embodiment is that the n⁺-type contact region 18 is formed, in addition to the p⁺-type collector region 15, in the n-type buffer region 14. Such a structure eliminates the need to connect a diode or a metal oxide semiconductor field effect transistor (MOSFET) in parallel with the lateral IGBT 4, to thereby effectively reduce an area of the semiconductor device 10, while effectively suppressing a thermal breakdown. Specifically, the p⁺-type contact region 13, the p-type well region 11, the n-type semiconductor layer 3, the n-type buffer region 14, and the n⁺-type contact region 18 form a parasitic diode 8. As illustrated in FIG. 6, the parasitic diode 8 has a cathode connected to the collector of the lateral IGBT 4 and an anode connected to the emitter of the lateral IGBT 4, and thus functions as a current path during a reverse conduction state. Accordingly, in the semiconductor device 10 of this embodiment, there is no need to form the diode or the MOSFET for securing the current path during the reverse conduction state, independently of the lateral IGBT 4, which effectively reduces the area of the semiconductor device 10. In addition, the n⁺-type contact region 18 also functions as a current path during a forward conduction state, and hence due to the n⁺-type contact region 18 thus provided, a current density of the collector part is reduced. The reduction in current density is effective in suppressing a thermal breakdown.

The embodiment of the present invention is described above in detail, but the present invention should not be interpreted limitedly to the embodiment. The IGBT of the present invention may be variously modified. For example, in FIG. 5, one p⁺-type collector region 15 and one n⁺-type contact region 18 are arranged adjacently to each other, but the arrangement of the p⁺-type collector region 15 and the n⁺-type contact region 18 may be variously modified. For example, a plurality of the p⁺-type collector regions 15 and a plurality of the n⁺-type contact regions 18 may be alternately arranged. The current driving performance of the lateral IGBT 4 changes based on the arrangement of the p⁺-type collector region(s) 15 and the n⁺-type contact region(s) 18. Therefore, the arrangement of the p⁺-type collector region (s) 15 and the n⁺-type contact region(s) 18 may be optimized in accordance with a required current driving performance.

Further, a person skilled in the art may easily understand that the function of the IGBT may be similarly obtained even in a case where a conductivity type of each of the semiconductor regions of the semiconductor device 10 of FIG. 5 is reversed. It should be noted that, even in this case, both the p⁺-type region and the n⁺-type region are formed in the buffer region of the collector part.

## Claims

1. An insulated gate bipolar transistor, comprising:
a substrate region; and
a collector part formed in a surface portion of the substrate region,
wherein the collector part includes:
a buffer region;
a p⁺-type region formed in the buffer region; and
an n⁺-type region formed in the buffer region.

2. An insulated gate bipolar transistor according to claim 1, further comprising:
an emitter part;
an insulating gate; and
a gate insulating film formed between the insulating gate and the substrate region,
wherein the buffer region includes an n-type semiconductor,
wherein the substrate region includes an n-type semiconductor, and
wherein the emitter part includes:
a p-type well region;
an n⁺-type emitter region formed in the p-type well region; and
a p⁺-type contact region formed in the p-type well region.

3. An insulated gate bipolar transistor according to claim 1, further comprising:
an emitter part;
an insulating gate; and
a gate insulating film formed between the insulating gate and the substrate region,
wherein the buffer region includes ap-type semiconductor,
wherein the substrate region includes a p-type semiconductor, and
wherein the emitter part includes:
an n-type well region;
a p⁺-type emitter region formed in the n-type well region; and
an n⁺-type contact region formed in the n-type well region.
